# EUROPÄISCHE PATENTSCHRIFT

(11) **EP 0 368 037 B1**
(45) Veröffentlichungstag und Bekanntmachung des Hinweises auf die Patenterteilung: **06.07.1994**
(21) Anmeldenummer: 89119229.6
(22) Anmeldetag: 17.10.1989
(51) Int. Cl.: H01J 37/302, H01J 37/305, C23C 14/30

(54) **Verfahren zur Steuerung der Verdampfungsratenverteilung eines Elektronenstrahls**
Process for controlling the distribution of the evaporation rate of an electron beam
Procédé de commande de la distribution du taux d'évaporation produite par un faisceau d'électrons

(30) Priorität: 10.11.1988 CH 4172/88
(43) Veröffentlichungstag der Anmeldung: 16.05.1990
(73) Patentinhaber: BALZERS AKTIENGESELLSCHAFT, 9496 Balzers (LI)
(72) Erfinder: Wegmann, Urs, Dipl. Ing. ETH, CH-9479 Oberschan (CH); Signer, Hans, CH-9479 Oberschan (CH); Koller, Albert, El. Ing. ETH, CH-7320 Sargans (CH)
(74) Vertreter: Troesch, Jacques J., Dr. sc. nat.

(56) Entgegenhaltungen:
- EP-A- 0 104 922
- EP-A- 0 222 219
- DE-A- 3 428 802

## Beschreibung

Die vorliegende Erfindung betrifft ein Verfahren zur Steuerung der mittels mindestens eines Elektronenstrahls über eine vorgegebene Verdampfungsfläche erzeugten, zeitlich gemittelten Verdampfungsrate, auf eine vorgegebene Verdampfungsratenverteilung über der Fläche, bei dem der Fläche ein Steuergrössenraster für mindestens einen Betriebsparameter des Elektronenstrahls zugeordnet wird und mit dem Elektronenstrahl, gesteuert mit den Steuergrössen des Rasters, die Fläche abgearbeitet wird, sowie eine Elektronenstrahlsteuerung.

Aus der EP-A-0 104 922 ist es bekannt, im Rahmen eines lithographischen Verfahrens mit einem leistungsschwachen, feinen Elektronenstrahl ein computergespeichertes Muster auf die Fläche eines IC's abzubilden. Dabei werden, ausgehend vom bekannten, abgespeicherten Zielmuster, gröbere Musterbereiche von feineren unterschieden und die Fläche des Strahls über den Bereichen, den jeweiligen Anforderungen entsprechend, konstant gehalten, um so die Strahlfläche nicht in jeder Strahlposition ändern zu müssen.

Während eine IC-Fläche eine kleine, plane, zeitlich konstante Bearbeitungsfläche für den nur um kleine Winkel abzulenkenden feinen Strahl darstellt und die Strahlwirkung im Rahmen des lithographischen Prozesses klar bestimmt ist, bildet eine verdampfte Fläche eine grosse, unregelmässig profilierte, zeitlich variierende Bearbeitungsfläche für den um relativ grosse Winkel umzulenkenden, leistungsstarken Elektronenstrahl, und es ist die jeweilige Strahlwirkung auf der Bearbeitungsfläche nicht von vornherein abschätzbar.

Nun ist aus der DE-A-34 28 802 ein Verfahren eingangs genannter Art bekannt geworden, wonach an einer vorgegebenen Verdampfungsfläche vorerst ein Positionsraster für den Elektronenstrahl zugeordnet wird und der Elektronenstrahl in Schritten von einem Rasterelement zum anderen über die Fläche geführt wird. Jedem Element des Positionsrasters, das beim Abarbeiten der Verdampfungsfläche durch den Elektronenstrahl angesteuert wird, ist eine eigene Steuergrösse zugeordnet, somit gleichviele Steuergrössen, wie am Positionsraster Positionselemente vorgesehen sind. Die einzelnen, je den Elementen des Positionsrasters zugeordneten Steuergrössen bilden gemeinsam somit ein der abzudampfenden Fläche zugeordnetes Steuergrössenraster für den Elektronenstrahl. Mit den Steuergrössen werden Betriebsparameter des Elektronenstrahls angesteuert, wie dessen Verweilzeit an einer durch das Positionsraster festgelegten Position, dessen dortige Fokussierung oder dessen Leistung. Zum Auffinden der den einzelnen Positionsrasterelementen zugehörigen Steuergrössen wird die Abdampfanlage eingefahren, und es werden diese Steuergrössen so lange verstellt, bis eine erwünschte Verdampfungsratenverteilung über der Fläche realisiert ist. Das Erreichen einer derartigen erwünschten Verdampfungsratenverteilung ist notwendig, um ein zu bedampfendes Gut nach vorgegebenen Kriterien, beispielsweise gleichförmig, in einer Vakuumbedampfungskammer der Anlage zu bedampfen.

Dieses bekannte Verfahren hat folgende Nachteile:
Beim Einfahren ist es sehr zeitaufwendig, da für jedes der Positionsrasterelemente bzw. -Inkremente die zugehörige Steuergrösse gefunden werden muss.

Im weiteren ist für das Abspeichern aller Steuergrössen, deren Anzahl der Anzahl Positionsrasterelemente entspricht, ein grosses Speicherangebot zur Verfügung zu stellen.

Im weiteren wird eine derartige Steuerung in der Regel im Betrieb relativ langsam, denn es muss bei jeder Positionsänderung des Elektronenstrahls, von einem Positionsrasterelement zum anderen, die neu einzustellende Steuergrösse mindestens abgefragt werden und allenfalls eingestellt werden, abgefragt in jedem Fall, auch wenn sich dabei zeigt, dass keine Steuergrössenänderung bei Uebergang von einer Position in die andere erfolgen muss.

Die vorliegende Erfindung setzt sich zum Ziel, ausgehend von einem Verfahren obgenannter Art, die erwähnten Nachteile zu beheben.

Dies wird erfindungsgemäss nach dem Wortlaut von Anspruch 1 erreicht.

Dadurch wird das wesentliche Merkmal erzielt, dass einer Mehrzahl von Strahlpositionen, bezüglich der abzudampfenden Fläche, die gleiche, konstante Korrekturgrösse zugeordnet wird, womit der Aufwand beim Einfahren bzw. Einschiessen der Anlage wesentlich geringer wird, da pro Gebiet, im weiteren Feld eines Korrekturgrössenrasters genannt mit konstanter Korrekturgrösse, nur die eine zugehörige Korrekturgrösse ermittelt werden muss. Das Einfahren wie für bestimmte zu verdampfende Materialien und/oder Verdampfungsflächenformen bleibt aber nötig. Darnach sind die Werte für den eingefahrenen Fall bekannt und können gleiche Fälle weiterverwendet werden.

Entsprechend wird der Speicheraufwand für die Korrekturgrössen des Korrekturgrössenrasters wesentlich verringert, und der Steuerungsprozess wird schneller, denn solange die Strahlposition nicht von einem Feld konstanter Korrekturgrösse ins nächste springt, kann, ohne Abfrage, die Korrekturgrösse konstant beibehalten werden. Dementsprechend muss lediglich detektiert werden, wann die Strahlposition die erwähnte Feldgrenze überschreitet.

Grundsätzlich geht die Erfindung dabei von der Erkenntnis aus, dass es nicht notwendig ist, entsprechend einem gleichmässig über der Fläche verteilten Positionsraster, für jedes Positionselement bzw. -Inkrement getrennt, Betriebsparametersteuergrössen bzw. Korrekturgrössen für den Elektronenstrahl vorzugeben. Die physikalischen Gegebenheiten, welche dazu führen, dass der Elektronenstrahl bei örtlich konstant gehaltenen Betriebsparametern, wie Fokussierung oder Verweilzeit, eine Verdampfungsratenverteilung bewirkt, die nicht einer erwünschten, insbesondere einer gleichförmigen Verteilung entspricht, sind nämlich nicht an jedem Positionsrasterelement unterschiedlich. So kann, beispielsweise wegen der Aussenkühlung des Tiegels, die Wärmeverteilung über der abzudampfenden Fläche durch in sich geschlossene Linien, eigentliche Isothermen, dargestellt werden, auf welchen Linien dieselben thermischen Verhältnisse vorliegen und mithin dieselben Korrekturgrössen zur Wirkung gebracht werden müssen. Ebenso können durch die Strahlumlenkung oder Fokussierungsänderungen entlang des abgedampften Profils bewirkte örtliche Aenderungen der Strahlverdampfungswirkung, durch Verbinden von Strahlpositionen, bei welchen die gleichen Aenderungen eintreten, kartenähnlich dargestellt werden.

Ausgehend von solchen Erkenntnissen, primär basierend auf der Betrachtung der physikalischen Einflussgrössen auf die Wechselwirkung Elektronenstrahl und Verdampfungsgut, wird mithin mindestens ein Korrekturgrössenraster erstellt, welches, ähnlich einer Landkarte bzw. einem Relief, Teilbereichen der Verdampfungsfläche zugeordnete Felder aufweist, je einer Mehrzahl von Strahlpositionen entsprechend und mit je konstanten Korrekturgrössen, womit die erwähnten Vorteile erwirkt werden.

In einer Weiterausbildung des genannten erfindungsgemässen Verfahrens wird nun vorgeschlagen, gemäss Anspruch 2 vorzugehen.

Dabei werden mehrere Korrekturgrössenraster je mit zugehörigen Feldereinteilungen vorgesehen, beispielsweise je einen der erwähnten physikalischen Einflüsse korrigierend. Das Steuergrössenraster, welches schliesslich auf einen Strahlbetriebsparameter, wie und vorzugsweise dessen Verweilzeit an einer Position und/oder dessen Fokussierung oder Leistung Einfluss nimmt, wird durch Verknüpfung der jeweiligen, einer Strahlposition zugeordneten Korrekturgrössen ermittelt, d.h., das gesamte Steuergrössenraster über der abzudampfenden Fläche durch Verknüpfung der vorgesehenen Korrekturgrössenraster gebildet.

Dabei wird, dem Wortlaut von Anspruch 3 folgend, weiter vorgeschlagen, dass bei Vorsehen mehrerer Korrekturgrössenraster, wie eben erläutert wurde, ein oder mehrere dieser Korrekturgrössenraster zur Bildung des Steuergrössenrasters wahlweise beigezogen werden können.

Bei Vorliegen eines einzelnen Korrekturgrössenrasters oder mehrerer, die dann gemeinsam ein komplexeres Steuergrössenraster durch die erwähnte Verknüpfung ergeben, kann der Elektronenstrahl, wie bis anhin üblich, davon unabhängig, in einem Positionsraster von Positionselement zu Positionselement geführt werden, wobei, bei entsprechender Verkleinerung der Positionselemente, die Strahlführung schliesslich in eine kontinuierliche Strahlführung übergeht.

Allerdings kann es dabei aus Gründen der Prozess-Schnelligkeit erwünscht sein, Grenzen zwischen den Feldern konstanter Korrekturgrössen eines vorgesehenen Korrekturgrössenrasters oder durch Vernüpfung der Felder mehrerer Korrekturgrössenraster entstandene Felder des Steuergrössenrasters konstanter Steuergrösse nicht unnötig oft zu überschreiten, um nicht unnötig oft Betriebsparameter des Elektronenstrahls bzw. deren Steller verstellen zu müssen. Dies insbesondere dann, wenn die Stellschrittantwort des Elektronenstrahls eine relativ lange Einschwingzeit aufweist.

Um in solchen Fällen die Prozessgeschwindigkeit, unter Berücksichtigung des erfindungsgemässen Korrekturgrössen-Feldaufbaus, zu optimieren, wird vorgeschlagen, nach Wortlaut von Anspruch 4 vorzugehen, d.h. den Elektronenstrahl dem minimalen Gradienten der Steuergrösse folgend zu führen oder gar automatisch den Weg nach dem erwähnten Gradientenminimum zu suchen.

Um nun im weiteren, im Rahmen individuell zu betreibender Bedampfungsanlagen, für welche bereits, beispielsweise bei der Prozessdefinition, Korrekturgrössenrasterfelder festgelegt wurden, eine Anpassung an individuelle Bedürfnisse des Betreibers vornehmen zu können, ohne dabei ein vollständiges Ermitteln sowohl der Felderverteilung wie auch der Korrekturgrössen-Werte vornehmen zu müssen, wird vorgeschlagen, nach Wortlaut von Anspruch 5 die Feldeinteilung vorzugeben und die Korrekturgrösseneinstellung individuell vorzunehmen, allenfalls um eine vorgegebene Grundeinstellung, letztere praktisch als feld-zugeordneter Arbeitspunkt.

Um im weiteren, ausgehend vom genannten Verfahren, bei welchem der Elektronenstrahl dem minimalen Gradienten der Steuergrössen automatisch folgt, zu verhindern, dass, z.B. bei mehrdeutiger Felderverteilung, beispielsweise bei unzusammenhängenden Feldern mit gleichen Steuergrössen, ein undefiniertes Hin- und Herspringen des Strahls von einem dem einen Feld zugehörigen Flächenbereich in den anderen erfolgt, wird vorgeschlagen, gemäss Wortlaut von Anspruch 6 den Elektronenstrahl dem minimalen Gradienten der Steuergrösse zu der Momentanposition benachbarten Strahlpositionen folgend, über die Fläche zu führen.

Im weiteren wird gemäss Wortlaut von Anspruch 7 vorgeschlagen, den Strahl in einer gewählten, gegebenenfalls von den Korrekturgrössenrastern und den Steuergrössenrastern entkoppelten Bahn zu führen.

Eine Elektronenstrahlsteuerung für eine Verdampfungsanlage mit einer Anlenkungssteuerung für den Strahl, welche die Strahlposition zur Abarbeitung einer Verdampfungsfläche über letztere steuert sowie mit einer Steuereinheit zur Steuerung von Strahlbetriebsparametern, zeichnet sich nach dem Wortlaut von Anspruch 8 aus.

Dabei gibt die Anlenkungssteuerung Positionsidentifikationssignale ab, die noch abzuarbeitende Strahlpositionen identifizieren. Bei vorgegebener Strahlführungsbahn identifiziert dabei die Anlenkungssteuerung die nächst abzuarbeitende, gegebene Strahlposition. Wenn aber im Sinne des erwähnten selbsttätigen Suchens einer optimalen Strahlführungsbahn nach dem Prinzip minimaler Steuergrössengradienten gearbeitet wird, so braucht die von der Anlenkungssteuerung identifizierte erwähnte Strahlposition nicht auch die nächst abzuarbeitende zu sein, denn hierzu muss, wie weiter spezifiziert werden wird, erst aus der Vielzahl oder mindestens den benachbarten, noch abzuarbeitenden Strahlpositionen diejenige ermittelt werden, welche den erwähnten minimalen Steuergrössengradienten ergibt.

Es sind im weiteren Speichermittel vorgesehen für das Abspeichern von Korrekturgrössen für Strahlbetriebsparameter sowie Zuordnungsmittel, welche mehreren Strahlpositionen dieselbe Speicherstelle der Speichermittel mit derselben Korrekturgrösse zuordnen, womit, wie verfahrensmässig eingangs erläutert wurde, gemeinsam für mehrere Strahlpositionen, sei dies einer vorgegebenen Strahlbahn oder einer selbsttätig gesuchten, Korrekturgrössenfelder konstanter Korrekturgrösse festgelegt sind. Die ausgegebenen Korrekturgrössen wirken nun als Steuergrösse auf mindestens einen Steuereingang der Steuereinheit für Strahlbetriebsparameter, insbesondere für dessen Strahlverweilzeit und/oder -Fokussierung und/oder -Leistung etc. Die Ablenkungssteuerung schliesslich führt den Strahl nach gefundener Steuergrösse in eine nächste Position. Diese entspricht wiederum entweder einer vorgegebenen - bei Strahlführung entlang einer vorgegebenen Bahn - oder einer vorermittelten Position.

Um nun im weiteren unnötige Steuergrössenausschläge zu verhindern, wird vorgeschlagen, nach dem Wortlaut von Anspruch 9 vorzugehen, laut welchem eine Selektionseinheit vorgesehen ist, welche, ausgehend von einer durch die Identifikationssignale gegebenen IST-Position des Strahls sowie von der dieser Position zugeordneten Speicherstelle des Korrekturgrössenspeichers und mithin von der momentanen Steuergrösse, eine Position für den Strahl sucht, deren zugeordnete, von der Korrekturgrösse im Korrekturgrössenspeicher abhängige Steuergrösse minimal von der Steuergrösse, die der Momentanposition entspricht, abweicht. Die Selektionseinheit sucht mithin eine nächste Strahlposition, so dass die notwendige Steuergrössenänderung minimal wird. Die Selektionseinheit gibt dann ein Positionssteuersignal an die Ablenkungssteuerung ab, um den Strahl in die gefundene Position als nächste Position zu steuern.

In einer weiteren Ausführungsvariante des erwähnten Minimumgradienten-Vorgehens wird, nach Wortlaut von Anspruch 10, vorgeschlagen, dass die Ablenkungssteuerung den Strahl in einem vorgegebenen Positionsraster über die Fläche steuert und die Selektionseinheit jeweils als nächste Position eine Position selektioniert, die der Momentanposition des Strahls benachbart ist. Damit wird bei einem vorgegebenen Positionsraster für den Strahl erreicht, dass nur jeweils benachbarte Positionen für die Selektion beigezogen werden.

Um im weiteren verschiedenartige physikalische Beeinflussungsgrössen auf die Strahlverdampfungswirkung optimal berücksichtigen zu können, wird vorgeschlagen, nach Wortlaut von Anspruch 11 vorzugehen. Demnach werden mehrere Speichermittel je für Korrekturgrössen vorgesehen, wobei die Zuordnungsmittel mehreren Strahlpositionen je Speicherstellen mit denselben Inhalten jeder Speichermittel zuordnen. Mit anderen Worten sind in jedem Speichermittel eigentliche Felder, dem erfindungsgemässen Verfahren folgend, festgelegt. Je die Korrekturgrössen aus den Speichermitteln sind auf eine Verknüpfungseinheit geführt, deren Ausgang mit mindestens einer Steuergrösse auf die Steuereinheit wirkt. Die Verknüpfungseinheit ist dabei bevorzugterweise eine additive oder multiplikative Einheit, wobei allenfalls noch Speichermittel zugeordnete Faktoren für eine additive Verknüpfung an der Verknüpfungseinheit eingestellt werden können.

Die Erfindung wird anschliessend beispielsweise anhand von Figuren erläutert.

Es zeigen:
- Fig. 1: ein kombiniertes Signalfluss-Funktionsblockdiagramm einer ersten Ausführungsvariante einer erfindungsgemässen Steuerung, welche nach dem erfindungsgemässen Verfahren arbeitet,
- Fig. 2: schematisch die Zuordnung der abzudampfenden Fläche, eines Strahl-Positionsrasters und eines Korrekturgrössenrasters,
- Fig. 3: eine erweiterte Ausführungsvariante einer erfindungsgemässen Steuerung zur Ausführung des erfindungsgemässen Verfahrens, wobei eine optimale Strahlführungsbahn ermittelt wird,
- Fig. 4: ausgehend von der erfindungsgemässen Steuerung gemäss Fig. 1 eine Weiterausbildung mit mehreren Feldzuordnungs- und Korrekturgrössenspeichern, wobei sich diese, ausgehend von der in Fig. 1 dargestellten Steuerung, mit den Vorkehrungen an der Steuerung gemäss Fig. 3 kombinieren lässt, für eine Strahlbahnoptimierung,
- Fig. 5a, Fig. 5b: zwei weitere durch Korrekturgrössenspeicher beispielsweise definierte Korrekturgrössenraster,
- Fig. 6: die Verteilung eines Steuergrössensignals, wie durch die Anordnung gemäss Fig. 4 erzeugt, bei multiplikativem Kreuzpunktoperator an einer Verknüpfungseinheit, und
- Fig. 7: die Verteilung eines Steuergrössensignals, wie es durch eine Verknüpfungseinheit an der Anordnung gemäss Fig. 4, bei additivem Kreuzpunktoperator resultiert.

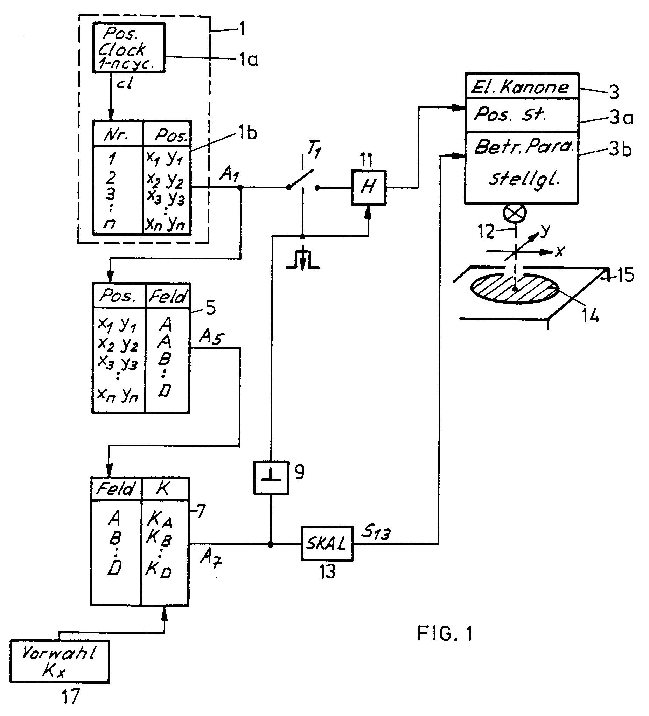

In Fig. 1 ist ein kombiniertes Signalfluss-Funktionsblockdiagramm einer ersten Ausführungsvariante einer erfindungsgemässen Steuerung zur Ausführung des erfindungsgemässen Verfahrens dargestellt.

Eine Auslenkungssteuereinheit 1 umfasst einen Positionstaktgeber 1a sowie eine Positionsspeicher 1b. Es seien bezüglich einer abzudampfenden Verdampfungsfläche 14, beispielsweise an einem Tiegel 15, durch ein Positionsraster in Positionen gegeben, die durch den Strahl 12 einer generell mit 3 bezeichneten Elektronenkanone abzuarbeiten sind. Im Positionsspeicher 1b sind die x, y Werte dieser anzusteuernden Strahlpositionen abgespeichert und ihrer Nummer nach, 1 bis n, an einem Ausgang A₁ ausgebbar. Der Positionstaktgeber 1a aktiviert über seinen Ausgang cl zyklisch den Positionsspeicher 1b, so dass letzterer an seinem Ausgang A₁ der Reihe nach die jeweils anzusteuernden x, y Werte ausgibt, die der Positionssteuerung 3a der Elektronenkanone 3 zugeführt werden. Es bilden mithin der Taktgeber 1a sowie der Positionsspeicher 1b einen fest einstellbaren Strahlbahngenerator.

Jedesmal, wenn über den Positionstaktgeber 1a ein nächster Positionswert x,y am Ausgang A₁ der Auslenkungssteuereinheit 1 ausgegeben wird, ist vorerst eine Durchschalteinheit T₁ geöffnet. Es wird das dann am Ausgang A₁ ausgegebene Positionssignal x,y einem Feldzuordnungsspeicher 5 zugeführt. Im Feldzuordnungsspeicher 5 sind jeder der n vorgesehenen Strahlpositionen x, y Feldidentifikationen A, B ... zugeordnet, wobei einer Mehrzahl Positionen x, y jeweils gemeinsam dieselben Feldidentifikationen angehören. Somit umfasst der Feldzuordnungsspeicher 5 wesentlich weniger Feldidentifikationen A, B ... als Strahlpositionen durch die Auslenkungssteuereinheit 1 anzusteuern sind. Durch Zuführung der nachmals anzusteuernden Strahlposition x, y vom Ausgang A₁ an den Feldzuordnungsspeicher 5 wird an seinem Ausgang A₅ die jeweilige Feldidentifikation ausgegeben.

Die Feldidentifikation, die nun am Ausgang A₅ des Feldzuordnungsspeichers 5 ausgegeben wird, wird einem Korrekturgrössenspeicher 7 zugeführt, worin für jede Feldidentifikation A, B ... je ein Korrekturwert K_{A}, K_{B} ... abgespeichert ist und der, entsprechend der am Ausgang A₅ anstehenden Feldidentifikation, am Ausgang A₇ den entsprechenden Korrekturgrössenwert K_{A}, K_{B} etc. ausgibt.

Somit wird, bei immer noch geöffneter Durchschalteinheit T₁, entsprechend der nachmals anzusteuernden x, y Strahlposition, am Ausgang des Korrekturgrössenspeichers 7 der dieser Position entsprechende Korrekturgrössenwert K ausgegeben, welcher dem Feld A bzw. B ... entspricht, worin die genannte Position lokalisiert ist.

Durch das Ausgeben der Korrekturgrösse K am Ausgang A₇ des Korrekturgrössenspeichers 7 wird über einen Impulsformer 9 die Durchschalteinheit T₁ geschlossen, so dass das immer noch am Ausgang A₁ anstehende Positionssignal x, y über eine Halteschaltung 11, welche ebenfalls vom Impulsformer 9 ausgelöst wird, der Positionssteuerung 3a der Elektronenkanone 3 zugeführt wird. Der ausgegebene Korrekturgrössenwert K seinerseits wird über eine Skalierungseinheit 13 als Steuergrössensignal einer Betriebsparameter-Stellgliedeinheit 3b zugespiesen und stellt dort einen Betriebsparameter für die Elektronenkanone 3, wie die Verweilzeit des Elektronenstrahls 12 am nun entsprechend dem anstehenden x,y Wert angesteuerten Punkt an der Verdampfungsfläche 14 oder dessen Fokussierung an diesem Punkt oder dessen Leistung an diesem Punkt.

Der Elektronenstrahl 12 arbeitet den nun angesteuerten Punkt ab, während die Durchschalteinheit T₁ wiederum geöffnet ist und durch den vorbeschriebenen Vorgang, erst über Anwahl der nächsten Positionsnummer, dann der neuen Position, der neuen Feldidentifikation und schliesslich der neuen Korrekturgrösse, die Einstellung für den nächsten abzuarbeitenden Punkt vorbereitet wird. Der Positionstaktgeber 1a schaltet, wie dargestellt, zyklisch die Positionsnummern 1 bis n an, so dass die abzudampfende Fläche 14 wiederholt abgearbeitet wird.

Mittels einer Vorwahleinheit 17 können die Korrekturgrössenwerte K am Korrekturgrössenspeicher 7 individuell eingestellt bzw. vorgewählt werden, bevorzugterweise verstellt, und zwar um einen vorab gespeicherten "Arbeitspunkt" im Korrekturgrössenspeicher 7.

Bei der derzeitigen Ausführungsvariante der erfindungsgemässen Steuerung wird als Betriebsparameter an der Betriebsparameter-Stellgliedeinheit 3b bevorzugterweise die Verweilzeit des Strahles 12 gestellt.

Bei der eingesetzten Elektronenkanone handelt es sich weiter z.B. um eine Elektronenkanone bekannter Bauart, wie einer Elektronenkanone ESQ 200 der Firma Balzers AG.

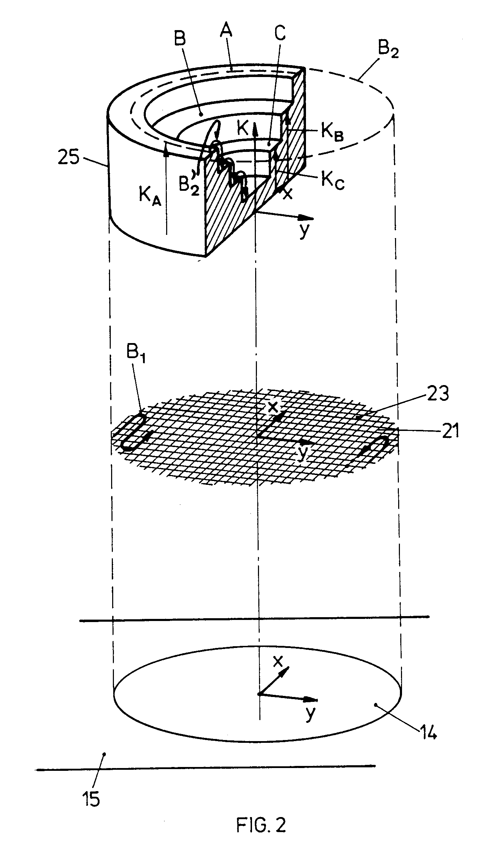

Anhand von Fig. 2 sei schematisch nochmals das erfindungsgemässe Vorgehen im Zusammenhang mit der in Fig. 1 dargestellten Ausführungsvariante der Steuerung erläutert.

Dabei bezeichnet wiederum die Positionsnummer 14 die gegebene, abzuarbeitende Verdampfungsfläche, beispielsweise im Verdampfungstiegel 15. Der Verdampfungsfläche 14 wird ein Positionsraster 21 für den Elektronenstrahl 12 zugeordnet. Dieses Positionsraster ist in eine Vielzahl gleicher Positionsinkremente 23, welche der Elektronenstrahl 12 ansteuern kann, unterteilt. Wie ersichtlich, geht dabei das Positionsraster 23 bei zunehmender Rasterfeinheit in ein kontinuierliches Raster über, d.h. in diesem Fall kann der Strahl kontinuierlich in jede beliebige Position bezüglich der Fläche 14 gesteuert werden.

Unabhängig von der Bahn, mit welcher kontinuierlich ode inkrementell der Strahl 12 bezüglich der Verdampfungsfläche 14 geführt ist, wird jeder Position des Strahls 12 relativ zur Fläche 14, entsprechend x, y, eine Korrekturgrösse K zugewiesen, wobei zu betonen ist, dass einer Vielzahl von Strahlpositionen x, y jeweils dieselbe Korrekturgrösse K zugeordnet ist, da eine Vielzahl Positionen dem gleichen Feld A, B ... zugehören. So ist ersichtlich, z.B. gemäss Fig. 2, dass allen Strahlpositionen, welche auf einem äusseren, peripheren Ring-Feld A liegen, die Korrekturgrösse K_{A} zugeordnet ist. Allen Strahlpositionen, welche auf einem anschliessenden, konzentrischen Ring-Feld B liegen, ist die Korrekturgrösse K_{B} zugeordnet und schliesslich weiteren konzentrischen, innenliegenden Ring-Feldern die Korrekturgrösse K_{C} etc.

Während die Korrekturgrössenwerte K gemäss Fig. 1 bevorzugterweise verstellbar sind, ist bevorzugterweise die Position/Feldzuteilung vorgegeben.

Im Positionsraster 21 ist eine erste Variante einer Strahlbahn bezüglich der Fläche 14 bei B₁ dargestellt. Wird eine solche Bahn B₁ von der Auslenkungssteuerung 1 gemäss Fig. 1 angesteuert, so folgt der Elektronenstrahl 12 einer die Fläche 14 in einem mäanderförmigen Muster abarbeitenden Bahn. Legt man diese Bahn B₁ auf das Korrekturgrössenraster 25, so ist ersichtlich, dass bei einem solchen, aus konzentrischen Kreis-Feldern gebildeten Raster 25 die aus den jeweiligen Korrekturgrössen K resultierende Steuergrösse S₁₃ von Fig. 1 allenfalls unerwünscht häufig geändert wird. Dies kann nun bei Bekanntsein des Korrekturgrössenrasters 25 auf einfache Art und Weise dadurch behoben werden, dass nicht eine mäanderförmige Bahn B₁ gewählt wird, sondern eine Bahn, welche von innen nach aussen oder von aussen nach innen in Kreisbahnen die Fläche 14 abarbeitet.

Bei Vorbekanntsein des Korrekturgrössenrasters oder -Profils, wie es in Fig. 2 beispielsweise dargestellt ist, kann nun gezielt an der Auslenkungssteuerung 1 von Fig. 1 eine optimalere Bewegungsbahn vorgegeben werden, wie beispielsweise die in Fig. 2 gestrichelt eingetragene Bahn B₂, wonach jedes der konzentrischen Felder A, B ... erst vollständig abgearbeitet wird, darnach auf das nächste Feld, wie bei B′₂ dargestellt, gesprungen wird, dieses Feld vollständig abgearbeitet wird, etc.

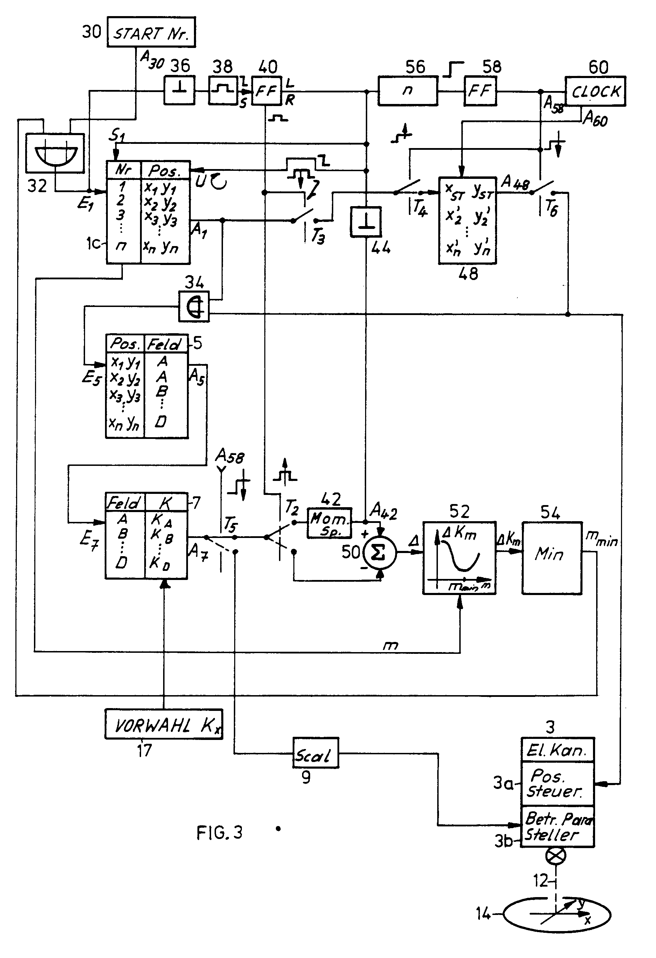

Die Vorgabe einer bestmöglichen Strahlbewegungsbahn, um den Elektronenstrahl 12 möglichst selten und mit möglichst kleinen Stellschritten verstellen zu müssen und um damit, je nach Einstellzeiten, den Prozess zu beschleunigen, ist dann ohne weiteres möglich, wenn das Korrekturgrössenraster vorab bekannt ist. Berücksichtigt man aber, dass, gemäss Fig. 1, individuelle Anpassungen der das Profil des Korrekturgrössenrasters 25 mitbestimmenden Korrekturgrössen K allenfalls möglich sind, so ist ersichtlich, dass nicht in jedem Fall mit einem solchen Vorabkennen des genannten Korrekturgrössenrasters 25 zu rechnen ist. Deshalb wird, wie in Fig. 3 dargestellt, eine weitere Ausführungsvariante der erfindungsgemässen Steuerung vorgeschlagen, bei welcher ein solcher optimaler Weg selbsttätig erst gesucht wird.

In Fig. 3 sind Funktionsblöcke, welche denjenigen von Fig. 1 entsprechen, mit denselben Positionsnummern versehen.

Der Aufbau der Steuerung gemäss Fig. 3 wird anhand ihrer Funktionsweise erläutert.

Zu Beginn wird an einer Startpositionsnummer-Vorgabeeinheit 30 eingegeben, an welcher Strahlposition der Bahnermittlungsprozess beginnen soll. Die am Ausgang A₃₀ erscheinende Positionsnummer wird über eine ODER-Verknüpfungseinheit 32 einem Positionsspeicher 1c zugespiesen. Im Positionsspeicher 1c sind die x,y Werte aller durch den Strahl 12 an der Verdampfungsfläche 14 abzuarbeitenden Punkte abgespeichert und sind durch Eingabe der zugeordneten Positionsnummern am Eingang E₁, am Ausgang A₁ ausgebbar.

Durch ein Signal am Steuereingang S₁ des Positionsspeichers 1c wird jeweils der Speicherinhalt entsprechend demjenigen x,y Wert gelöscht, dessen Positionsnummer am Eingang E₁ ansteht. Durch ein weiteres Steuersignal U wird der Positionsspeicher 1c zur zyklischen, einmaligen Ausgabe aller in ihm verbleibenden Positionswerte x,y angesteuert.

Analog zur Ausführungsvariante von Fig. 1 erscheint nun am Ausgang A₁ der der Startnummer entsprechende Positionswert x, y und wird über eine ODER-Verknüpfungseinheit 34 an den Eingang E₅ des Feldzuordnungsspeichers 5 gespiesen, worauf letzterer die der Position entsprechende Feldidentifikation A, B ... am Ausgang A₅ ausgibt. Die Feldidentifikation wird nun vom Ausgang A₅ an den Eingang E₇ des Korrekturgrössenspeichers 7 gespiesen, worauf letzterer in vorbeschriebener Art und Weise die dem identifizierten Feld entsprechende Korrekturgrösse K_{A} bzw. K_{B} ... am Ausgang A₇ abgibt.

Bei Erscheinen der Startnummer am Eingang E₁ des Positionsspeichers 1c wird, beispielsweise über einen Impulsformer 36, eine Zeitverzögerung 38 und eine bistabile Einheit 40, eine Umschaltereinheit T₂ in die in Fig. 3 ausgezogen dargestellte Position geschaltet, und der am Ausgang A₇ erscheinende Korrekturgrössenwert einem Momentanwertspeicher 42 eingegeben. Sobald dieser Korrekturgrössenwert im Momentanwertspeicher 42 eingegeben ist und an dessen Ausgang A₄₂ erscheint, wird, beispielsweise über einen Impulsformer 44, die bistabile Einheit 40 rückgesetzt, worauf die Umschaltereinheit T2 in die gestrichelt dargestellte Position rückfällt.

Der Ausgangsimpuls des Impulsformers 44 wird weiter dem Rücksetzeingang S₁ zugespiesen, wodurch der Speicherinhalt des Positionsspeichers 1c gelöscht wird, der durch die am Eingang E₁ anstehende Positionsnummer definiert ist. Mithin wird bei Erscheinen des im Momentanwertspeicher 42 eben abgespeicherten Korrekturgrössenwertes am Positionsspeicher 1c der der Startposition entsprechende Speicherinhalt gelöscht. Dieser Positionswert ist aber nicht verloren, denn er wurde während der momentanen Abspeicherung der zugehörigen Korrekturgrösse, durch Schliessen einer Durchschalteinheit T₃ und in gestrichelter Position geschalteter Durchschalteinheit T₄, einem Optimalbahn-Positionsspeicher 48 eingegeben. Dies erfolgte durch Schliessen der Durchschalteinheit T₃ mit dem auch die Umschalteinheit T₂ auf den Speicher 42 schaltenden Ausgangssignal der bistabilen Einheit 40.

Nach Umlegen der Umschalteinheit T2 in die gestrichelt dargestellte Position ist somit der Speicherinhalt entsprechend der Startpositionsnummer im Positionsspeicher 1c gelöscht, ist aber im Optimalbahn-Positionsspeicher 48 abgelegt.

Durch den Impuls der Einheit 44 wird der Steuereingang U zum Positionsspeicher 1c angesteuert, worauf der Positionsspeicher 1c in einem Zyklus alle verbleibenden x,y Positionswerte an seinen Ausgang A₁ ausgibt. Ueber die ODER-Verknüpfungseinheit 34, den Feldzuordnungsspeicher 5 und den Korrekturgrössenspeicher 7, eine in ausgezogener Position geschaltete Umschalteinheit T5 werden somit zyklisch alle den im Positionsspeicher 1c verbleibenden Positionen entsprechenden Korrekturgrössenwerte K einer Differenzeinheit 50 zugeführt, zusammen mit dem im Momentanwertspeicher 42 abgelegten Korrekturgrössenwert.

Die Differenz Δ der Korrekturgrössen K aller im Positionsspeicher 1c verbleibenden Positionen werden einer Differenzspeichereinheit 52 zugeführt, und zwar gleichzeitig mit der dem Positionsspeicher 1c entnommenen, jeweiligen Positionsnummer m, wobei im Speicher 52 jeweils eine Korrekturgrössendifferenz ΔK mit der Nummer der Position m abgespeichert wird, deren Korrekturgrösse mit der im Speicher 42 abgelegten Korrekturgrösse in Beziehung gesetzt wurde.

Nachdem am Ausgang A₁ des Positionsspeichers 1c alle verbleibenden Positionen ausgegeben wurden, ist somit im Differenzspeicher 52 die folgende Funktion abgelegt: Korrekturgrössenwertdifferenz aller Korrekturgrössen, welche den im Positionsspeicher 1c verbleibenden Positionen entsprechen, zu dem der Startposition entsprechenden Korrekturgrössenwert in Funktion der Positionsnummer m. Diese Funktion ΔKₘ, die nach einmaligem Umwälzen des Positionsspeichers 1c im Differenzspeicher 52 liegt, wird einer Minimumbestimmungseinheit 54 zugespiesen, welche detektiert, bei welcher Positionsnummer mₘᵢₙ die Differenz ΔKₘ im Differenzspeicher 52 minimal ist. Diese Positionsnummer mₘᵢₙ wird der ODER-Einheit 32 zugespiesen, dann dem Eingang E₁ des Positionsspeichers 1c. Diese neu gefundene Positionsnummer wirkt nun genau gleich wie die vorab zum Starten des Prozesses eingegebene Startnummer von Ausgang A₃₀:
Entsprechend der Nummer mₘᵢₙ erscheint am Ausgang des Positionsspeichers 1c die zugeordnete x,y Position, wird über die ODER-Verknüpfungseinheit 34 dem Feldzuordnungsspeicher 5 zugespiesen, dessen Ausgang dem Korrekturgrössenspeicher 7, dessen Ausgang wiederum erst dem Momentanwertspeicher 42, wo er zwischengespeichert wird. Der ausgegebene Positionswert am Ausgang A₁ wird weiter dem Optimalbahn-Positionsspeicher 48 als nächste Position x2′, y2′ zugespiesen, darnach im Positionsspeichers 1c mit wird, durch Umwälzen des Positionsspeicher 1c gelöscht. Dann den noch verbleibenden Positionswerten, wiederum die Korrekturgrössendifferenz in Funktion der im Positionsspeicher 1c verbleibenden Positionsnummern im Speicher 52 abgelegt, darnach an der Minimumbestimmungseinheit 54 die neue Minimum-Nummer mₘᵢₙ ermittelt etc.

Wie ersichtlich, verbleibt im Positionsspeicher 1c nach jedem derartigen Umgang eine Positionsnummer mit den entsprechenden Positions-x,y-Werten weniger, bis alle vormals im Positionsspeicher 1c abgespeicherten Positions-x,y-Werte, in neuer Reihenfolge, im Optimalbahn-Positionsspeicher 48 abgelegt sind. Die nun in diesem Speicher 48 abgelegte Positionsreihenfolge entspricht einer Bewegungsbahn für den Strahl 12 der Elektronenkanone 3, bei welcher sichergestellt ist, dass, von Position zu Position fortschreitend, jeweils minimale Korrekturgrössenschritte durchgeführt werden müssen.

Ein Zähler 56 zählt, wie oft der Momentanwertspeicher 42 geladen wurde, und steuert, sobald sein Zählstand der Anzahl anzusteuernder Strahlpositionen n entspricht, eine bistabile Einheit 58 an. Dies zeigt an, dass die erwähnte optimale Bahn im Optimalbahnspeicher 48 abgelegt ist. Nun ist der Suchprozess für diese optimale Bahn abgeschlossen, und der nun einsetzende Positioniervorgang für den Strahl 12 der Elektronenkanone 3 wird, ausgehend von diesem Optimalbahnspeicher 48 angesteuert, der nun anstelle des Positionsspeichers 1c tritt: Das Ausgangssignal der bistabilen Einheit 58 öffnet hierzu die Durchschalteinheit T₄ und schliesst eine weitere Durchschalteinheit T₆ ausgangsseitig des Optimalbahn-Positionsspeichers 48, womit dessen Ausgang A₄₈ auf die ODER-Verknüpfungseinheit 34 geschaltet wird. Gleichzeitig wird der Ausgang A₄₈ durch Schliessen der Durchschalteinheit T₆ auf den Positionssteuereingang an der Elektronenkanone 3 geführt. Ebenfalls durch das Ausgangssignal A₅₈ der bistabilen Einheit 58 wird die Umschaltereinheit T₅ in die gestrichelt dargestellte Position gelegt, womit der Ausgang A₇ des Korrekturgrössenspeichers 7 über die Skalierungseinheit 9 der Betriebsparameterstellereinheit 3b der Elektronenkanone 3 zugespiesen wird.

Durch das Ausgangssignal A₅₈ der bistabilen Einheit 58 wird weiter ein Taktgeber 60 ausgelöst, dessen Ausgangssignal A₆₀ nun der Reihe nach, und somit der optimalen Bahn entsprechend, die Positionssignale aus dem Optimalbahn-Positionsspeicher 48 austaktet, womit einerseits, über die Positionssteuerung 3a die Elektronenkanone 12 dieser Optimalbahn folgt, und anderseits, über die ODER-Verknüpfungseinheit 34, den Feldzuordnungsspeicher 5 und den Korrekturgrössenspeicher 7 jeweils der gewählte Betriebsparameter, wie die Strahlverweilzeit, dessen Fokussierung oder Leistung, an der Betriebsparameterstellereinheit 3b gestellt wird.

In gewissen Fällen kann es z.B. aus Gründen von Mehrdeutigkeiten bezüglich des Minimums, das an der Minimumbestimmungseinheit 54 aufzufinden ist, angezeigt sein, vorab die Anzahl Punkte, bezüglich welcher die Korrekturgrössendifferenzen ΔK zu bilden sind, einzuschränken. Ein solches Einschränkungskriterium kann dabei sein, dass nur die Korrekturgrössendifferenzen von Punkten zu bilden sind, die in den x- und y-Koordinaten einander benachbart sind. Hierzu wird dann jeweils der Positionsspeicher 1c nicht zum Umwälzen aller in ihm verbleibenden Speicherinhalte mit dem Steuersignal U angesteuert, sondern es werden jeweils nur die in x und y nächst numerierten Positionen zur Differenzbildung angesteuert. Dies heisst, dass, wenn im Momentanspeicher 42 ein dem Punkt xᵣ, yᵣ entsprechender Korrekturwert abgelegt ist, diesbezüglich nur die Differenzen entsprechend den Punkten x_{r±1}, yᵣ bzw. xᵣ, y_{r±1} untersucht werden, allenfalls auch die Punkte x_{r±1}, y_{r±1}.

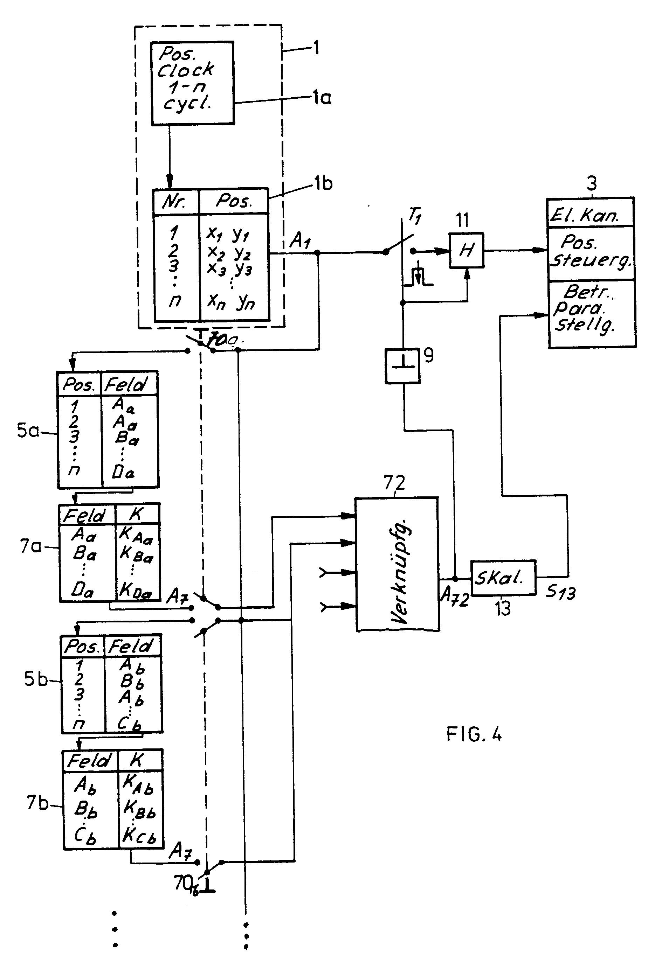

In Fig. 4 ist eine weitere Ausführungsvariante der erfindungsgemässen Anlage, ausgehend von ihrer Konfiguration gemäss Fig. 1, dargestellt, d.h. mit vorgegebener Strahlbahnführung. Wie ersichtlich werden wird, ist es gerade bei einer solchen Weiterbildung möglicherweise angezeigt, die Anlage mit den die optimale Strahlbahn suchenden Vorkehrungen, wie sie anhand von Fig. 3 dargestellt wurden, auszubauen, wobei dieser Ausbau in Analogie zur Darstellung von Fig. 3 erfolgt.

Funktionsblöcke und Signale, die denjenigen von Fig. 1 entsprechen, sind in Fig. 4 mit denselben Positionszeichen versehen.

Bei der Ausbildungsvariante gemäss Fig. 4 gibt die Auslenkungssteuerung 1, betrieben wie die in Fig. 1 dargestellte, an ihrem Ausgang A₁ und getaktet vom Positionstaktgeber 1a das jeweilige Positionssignal x,y ab. Es ist nun eine Mehrzahl einander zugehöriger Sätze jeweils eines Feldzuordnungsspeichers und eines Korrekturgrössenspeichers 5a/7a, 5b/7b etc. vorgesehen. Allen anzusteuernden n Strahlpositionen x, y sind in jedem dieser Sätze eine Feldverteilung zugeordnet, so beispielsweise im Satz "a" die Felder Aₐ, Bₐ ..., Dₐ und im Satz "b" die Felder A_{b}, B_{b} ..., C_{b}, die im allgemeinen Fall nicht übereinstimmen. Diesen satzspezifischen Feldern sind in den zugeordneten Korrekturgrössenspeichern 7ₐ bzw. 7_{b} die entsprechenden Korrekturgrössen K beigefügt.

Es sind zwei oder mehr derartiger Feldzuordnungs-/Korrekturgrössenspeicher-Sätze vorgesehen, welche je einzeln oder in beliebigen Kombinationen für einen jeweilig anzusteuernden Abarbeitungsprozess aufgeschaltet werden können. Hierzu sind schematisch dargestellte Zuschalt-Anordnungen 70 vorgesehen, mittels welcher einerseits der Ausgang A₁ in Analogie zu den Ausführungen von Fig. 1, nun aber selektiv, einem oder mehreren der Feldzuordnungsspeicher 5 zugeschaltet werden kann. Entsprechend werden die Ausgänge A₇ eines oder mehrerer der vorgesehenen Sätze 5/7 auf eine Verknüpfungseinheit 72 geschaltet.

An der Verknüpfungseinheit werden alle an den jeweils aktivierten Ausgängen A₇ ausgegebenen Korrekturgrössen miteinander verknüpft, bevorzugterweise allenfalls gewichtet addiert oder multipliziert, so dass am Ausgang A₇₂ der Verknüpfungseinheit 72 ein Signal auftritt, über die Skalierungseinheit 13, in das Stellsignal S₁₃ gewandelt, das eine Funktion der Korrekturgrösse(n) ein oder mehrerer, der aufgeschalteten Feldzuordnungs-/Korrekturgrössenspeicher-Sätze 5/7 ist.

In jedem der vorgesehenen Sätze 5/7 ist ein vorzugsweise dem Einfluss einer physikalischen Grösse auf die Wirkung des Elektronenstrahls 12 bezüglich der abzudampfenden Fläche 14 entsprechendes Korrekturgrössenraster in Analogie zum Korrekturgrössenraster 25 von Fig. 2 abgespeichert. So sind beispielsweise im Feldzuordnungs-/Korrekturgrössenspeicher-Satz "a" die Felder und Korrekturgrössen eines Kreisringfeld-Korrekturgrössenrasters, wie in Fig. 2 dargestellt, abgespeichert. Ein Korrekturgrössenraster mit diesem Profil trägt, an einem axialsymmetrischen Verdampfungstiegel, den thermischen Diffusionsverhältnissen zur gekühlten Tiegelaussenwand Rechnung, die mittels kreisringförmiger Isothermen darstellbar sind.

Im zweiten Feldzuordnungs-/Korrekturgrössenspeicher-Satz "b" sind beispielsweise Feld- und Korrekturgrössenverhältnisse abgespeichert, die ein Korrekturgrössenraster, wie es in Fig. 5a dargestellt ist, definieren, welches dem Einfluss der sich ändernden Fokussierung bei der Ablenkung eines Elektronenstrahls Rechnung trägt, der zwischen Elektronenstrahlquelle und Verdampfungsfläche 14 eine 270° Umlenkung erfährt, in einer senkrecht zur Verdampfungsfläche stehenden Ebene, z.B. durch die y-Achse.

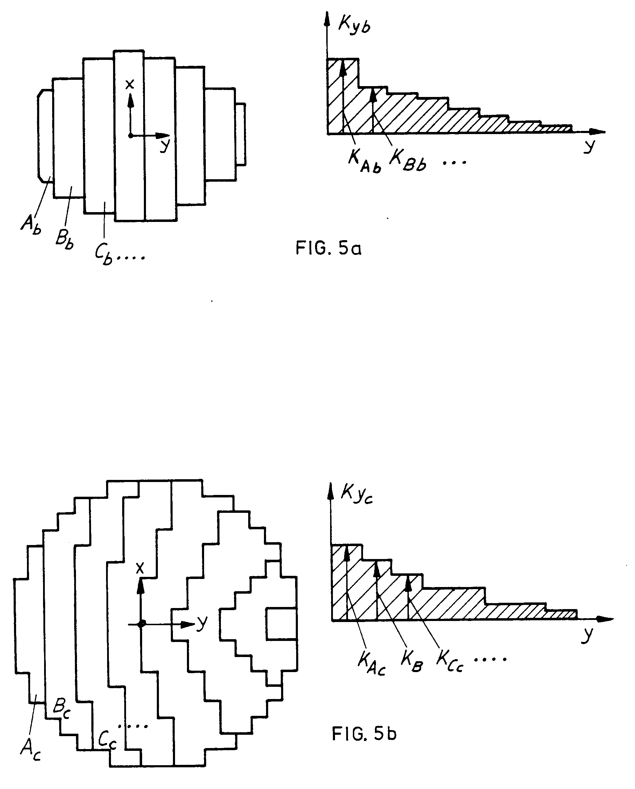

Durch einen weiteren, in Fig. 4 nicht dargestellten Feldzuordnungs-/Korrekturgrössenspeicher-Satz wird beispielsweise ein Korrekturgrössenraster mit dem Profil gemäss Fig. 5b definiert, welches, mit sichelförmigen Feldern, dem Einfluss der seitlichen Ablenkung in x-Richtung, beispielsweise der erwähnten Elektronenstrahlkanone, Rechnung trägt, bei der ab Elektronenstrahlquelle der Strahl erst um 270° in einer Ebene senkrecht zur Abdampfebene 14 und durch die eingezeichnete y-Achse umgelenkt wird.

Wie in Fig. 4 dargestellt, wird durch die Zuschaltanordnung 70 festgelegt, welche der Korrekturgrössenraster bei einem beabsichtigten Verdampfungsprozess eingesetzt werden sollen. Dabei ist nochmals zu betonen, dass jeweils eine Strahlposition x,y in jedem Satz einem anderen Feld zugehören kann und mithin an jedem Satz eine andere Korrekturgrösse abruft, und dass alle Korrekturgrössen - ein oder mehrere - zur Bildung des Stellsignals S₁₃ schliesslich an der Verknüpfungseinheit 72 vorzugsweise multiplikativ oder additiv miteinander verknüpft werden.

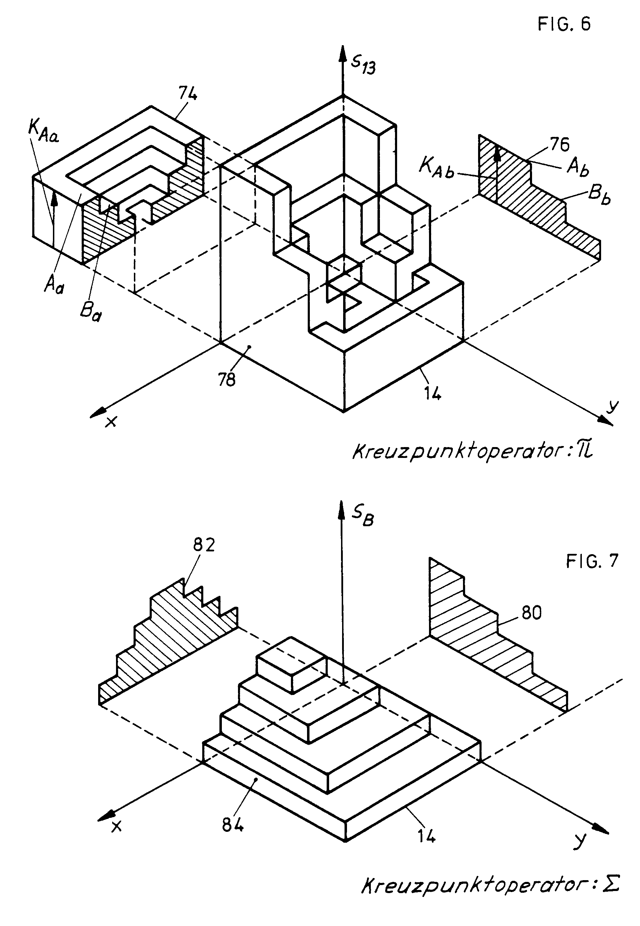

In Fig. 6 ist das Steuergrössensignal S₁₃ dargestellt, wenn zwei Feldzuordnungs-/Korrekturgrössenspeicher-Sätze 5/7 eingesetzt sind, wobei mit dem einen Satz ein Korrekturgrössenraster, wie bei 74 dargestellt, definiert werde, mit dem anderen Satz ein Korrekturgrössenraster wie bei 76 dargestellt. Bei Auslegung der Verknüpfungseinheit 72 von Fig. 4 als Multiplikationseinheit, woran die den Feldern zugeordneten Korrekturgrössenwerte K miteinander multipliziert werden, ergibt sich ein Verlauf des Steuergrössensignals S₁₃ über der x,y Ebene, d.h. eigentlich der Verdampfungsfläche 14, wie bei 78 in Fig. 6 dargestellt ist. Bei additiver Verknüpfung an der Verknüpfungseinheit 72 ergibt sich bei den in Fig. 7 dargestellten Korrekturgrössenrastern 80 und 82 ein Steuergrössensignalverlauf über der Verdampfungsfläche 14, wie bei 84 dargestellt.

Nach erster Abschätzung der Korrekturgrössen, anhand physikalischer Symmetrien, wie bezüglich Wärmediffusion, werden genauere Grössen bevorzugterweise durch das Experiment festgelegt und festgehalten.

## Patentansprüche

1. Verfahren zur Steuerung der mittels mindestens eines Elektronenstrahls (12) über eine vorgegebene Verdampfungsfläche (14) erzeugten, zeitlich gemittelten Verdampfungsrate, auf eine vorgegebene Verdampfungsratenverteilung über der Fläche (14), bei dem der Fläche (14) ein Steuergrössenraster für mindestens einen Betriebsparameter des Elektronenstrahls zugeordnet wird, und mit dem Elektronenstrahl (12), gesteuert mit den Steuergrössen des Rasters, die Fläche (14) abgearbeitet wird, dadurch gekennzeichnet, dass das Steuergrössenraster durch mindestens ein der Fläche (14) zugeordnetes Korrekturgrössenraster (25) gebildet wird, das in Teilbereichen der Fläche zugeordnete Felder (A, B, C ...) unterteilt ist, worin die jeweilige Korrekturgrösse (K_{A}, K_{B}, K_{C},...) konstant ist und wobei die Teilbereiche der Fläche Teilbereiche umfassen, die grösser sind, als dass sie durch den darin stationär gehaltenen Elektronenstrahl abgearbeitet werden könnten.

2. Verfahren nach Anspruch 1, dadurch gekennzeichnet, dass mehrere Korrekturgrössenraster (74, 76) je mit Feldereinteilungen (Aₐ, Bₐ, A_{b}, B_{b}) vorgesehen werden und das Steuergrössenraster (78, 84) durch eine Verknüpfung gleichen Positionen (x, y) entsprechender Korrekturgrössen (K_{Aa}, K_{Ab}...) erstellt wird.

3. Verfahren nach einem der Ansprüche 1 oder 2, dadurch gekennzeichnet, dass das Steuergrössenraster (78, 84) aus einem oder mehreren Korrekturgrössenraster(n) (74, 76) erstellt wird, vorzugsweise durch selektives Auswählen einer Kombination aus einer Mehrzahl vorgesehener Korrekturgrössenraster.

4. Verfahren nach einem der Ansprüche 1 bis 3, dadurch gekennzeichnet, dass der Elektronenstrahl (12), dem minimalen Gradienten (Δ) der Steuergrössen folgend, über die Tiegelfläche (14) geführt wird, allenfalls automatisch.

5. Verfahren nach einem der Ansprüche 1 bis 4, dadurch gekennzeichnet, dass die Feldeinteilung (A, B ..) des oder der Korrekturgrössenraster (74, 76) vorgegeben wird und die Korrekturgrösseneinstellung (K) individuell mittels einer Vorwahleinheit (17) vorgenommen wird, allenfalls um eine ebenfalls vorgegebene Grundeinstellung.

6. Verfahren nach Anspruch 4, dadurch gekennzeichnet, dass der Elektronenstrahl (12), den minimalen Steuergrössengradienten (Δ) benachbarter Strahlpositionen folgend, über die Fläche (14) geführt wird.

7. Verfahren nach einem der Ansprüche 1 bis 6, dadurch gekennzeichnet, dass der Strahl in einer wählbaren Bahn (B₁, B₂, B'₂,) über die Tiegelfläche (14) geführt wird.

8. Elektronenstrahlsteuerung für eine Verdampfungsanlage mit einer Ablenkungssteuerung (1) für den Strahl (12), welche die Strahlposition (x, y) zur Abarbeitung einer Verdampfungsfläche (14) über letztere steuert, sowie mit einer Steuereinheit (3b) zur Steuerung von Strahlbetriebsparametern, dadurch gekennzeichnet, dass
- die Ablenkungssteuerung (1) ein Positionsidentifikationssignal (Nr) abgibt, das eine Strahlposition (x, y) identifiziert, welche einer Position auf der Fläche (14) entspricht, die noch weniger abgearbeitet ist als andere Positionen der Fläche des Tiegels,
- Speichermittel (7) für das Abspeichern von Korrekturgrössen (K) für Strahlbetriebsparameter vorgesehen sind,
- Zuordnungsmittel (5) vorgesehen sind, die Speicherstellen der Speichermittel (7) mit derselben Korrekturgrösse (K) zuordnen und ausgeben,
- die ausgegebenen Korrekturgrössen (K) als Steuergrösse (S₁₃) auf mindestens einen Steuereingang der Steuereinheit (3b) geführt sind,
- die Ablenkungssteuerung (1) den Strahl (12) in eine nächste Position steuert.

9. Steuerung nach Anspruch 8, dadurch gekennzeichnet, dass eine Selektionseinheit (52, 54) vorgesehen ist, welche, ausgehend von einer durch ein Identifikationssignal (Nr) gegebenen IST-Position des Strahls (12) sowie der dieser Position zugeordneten Speicherstelle des Korrekturgrössenspeichers (7) und mithin der momentanen Steuergrösse, eine Position für den Strahl (12) sucht, deren zugeordnete, von der Korrekturgrösse im Korrekturgrössenspeicher (7) abhängige Steuergrösse, minimal von der Steuergrösse, die von der Korrekturgrösse entsprechend der Momentanposition abhängt, abweicht, und dass die Selektionseinheit (54) ein Positionssteuersignal (mₘᵢₙ) für den Strahl (12) abgibt, um den Strahl (12) in die gefundene Position als nächste Position zu steuern.

10. Steuerung nach einem der Ansprüche 8 oder 9, dadurch gekennzeichnet, dass die Ablenkungssteuerung (1) den Strahl (12) in einem vorgegebenen Positionsraster über die Fläche (14) steuert und die Selektionseinheit (52, 54) jeweils als nächste Position eine Position selektioniert, die der Momentanposition in diesem Raster benachbart ist.

11. Steuerung nach einem der Ansprüche 8 bis 10, dadurch gekennzeichnet, dass mehrere Speichermittel (7ₐ, 7_{b}...) je für Korrekturgrössen (K_{Xa}, K_{Xb}...) vorgesehen sind, dass die Zuordnungsmittel (5a, 5b ..) mehreren Strahlpositionen je Speicherstellen mit denselben Inhalten (K) in jedem Speichermittel (7ₐ, 7_{b}...) zuordnen, dass die Ausgänge der Speichermittel (7ₐ, 7_{b}...) auf eine Verknüpfungseinheit (72) wirken, deren Ausgang (S₁₃) mit mindestens einer Steuergrösse auf die Steuereinheit (3b) wirkt.

12. Steuerung nach Anspruch 11, dadurch gekennzeichnet, dass ein oder mehrere der Speichermittel (7ₐ, 7_{b}...) mittels einer Zuschaltanordnung (70) einsetzbar sind.

13. Steuerung nach einem der Ansprüche 8 bis 12, dadurch gekennzeichnet, dass die Korrekturgrössen (K) an den Speichermitteln (7) an einer Vorwahleinheit (17) extern verstellbar sind.

14. Steuerung nach einem der Ansprüche 8, 11 bis 13, dadurch gekennzeichnet, dass die Ablenkungssteuerung (1) einen fest einstellbaren Strahlbahngenerator (1a, 1b) umfasst.

## Claims

1. A method of controlling the time-averaged evaporation rate which is produced by means of at least one electron beam (12) over a predetermined evaporation area (14) to give a predetermined evaporation rate distribution over the area (14), wherein associated with the area (14) is a control value grid for at least one operating parameter of the electron beam, and the area (14) is worked off with the electron beam (12), controlled with the control values of the grid, characterised in that the control value grid is formed by at least one correction value grid (25) which is associated with the area (14) and which is subdivided into fields (A, B, C ...) associated with portions of the area, in which the respective correction value (K_{A}, K_{B}, K_{C}, ...) is constant, and wherein the portions of the area include portions which are larger than could be worked off by the electron beam when held stationarily therein.

2. A method according to claim 1 characterised in that there are provided a plurality of correction value grids (74, 76) each with field divisions (Aₐ, Bₐ, A_{b}, B_{b}), and the control value grid (78, 84) is provided by combining correction values (K_{Aa}, K_{Ab} ...) corresponding to identical positions (x, y).

3. A method according to one of claims 1 and 2 characterised in that the control value grid (78, 84) is produced from one or more correction value grids (74, 76), preferably by selective selection of a combination from a plurality of provided correction value grids.

4. A method according to one of claims 1 to 3 characterised in that the electron beam (12), following the minimum gradient (Δ) of the control values, is guided over the crucible surface area (14), possibly automatically.

5. A method according to one of claims 1 to 4 characterised in that the field division (A, B ...) of the correction value grid or grids (74, 76) is predetermined and the correction value setting (K) is effected individually by means of a preselection unit (17), possibly around a base setting which is also predetermined.

6. A method according to claim 4 characterised in that the electron beam (12) is guided over the area (14), following the mind control value gradients (Δ) of adjacent beam positions.

7. A method according to one of claims 1 to 6 characterised in that the beam is guided in a selectible path (B₁, B₂, B'₂) over the crucible surface area (14).

8. An electron beam control for an evaporation installation having a deflection control (1) for the beam (12) which controls the beam position (x, y) for working off an evaporation area (14) over the latter, and a control unit (3b) for controlling beam operating parameters, characterised in that
- the deflection control (1) produces a position identification signal (Nr) identifying a beam position (x, y) which corresponds to a position on the area (14), which is still less worked off than the other positions of the area of the crucible,
- there are provided storage means (7) for the storage of correction values (K) for the beam operating parameters,
- there are provided association means (5) which associate and output storage locations of the storage bans (7) with the same correction value (K),
- the outputted correction values (K) are passed as a control value (S₁₃) to at least one control input of the control unit (3b), and
- the deflection control (1) controls the beam (12) into a next position.

9. A control according to claim 8 characterised in that there is provided a selection unit (52, 54) which, starting from an actual position of the beam (12) which is given by an identification signal (Nr) and the storage location, associated with that position, in the correction value storage means (7) and accordingly the instantaneous control value, searches for a position for the beam (12) whose associated control value which is dependent on the correction value in the correction value storage means (7) deviates to the minimum extent from the control value which depends on the correction value in accordance with the instantaneous position, and that the selection unit (54) outputs a position control signal (mₘᵢₙ) for the beam (12) to control the beam (12) into the found position as the next position.

10. A control according to one of claims 8 and 9 characterised in that the deflection control (1) controls the beam (12) in a predetermined position grid over the area (14) and the selection unit (52, 54) respectively selects as the next position a position which is adjacent to the instantaneous position in said grid.

11. A control according to one of claims 8 to 10 characterised in that there are provided a plurality of storage means (7ₐ, 7_{b} ...) respectively for correction values (K_{Xa}, K_{Xb} ...), that the association means (5a, 5b ...) associate with a plurality of beam positions respective storage locations having the same contents (K) in each storage bans (7ₐ, 7_{b} ...) and that the outputs of the storage (7ₐ, 7_{b} ...) act on a combining unit (72) whose output (S₁₃) acts with at least one control value on the control unit (3b).

12. A control according to claim 11 characterised in that one or more of the storage means (7ₐ, 7_{b} ...) can be brought into operation by means of a switch-on arrangement (70).

13. A control according to one of claims 8 to 12 characterised in that the correction values (K) at the storage bans (7) are externally adjustable at a preselection unit (17).

14. A control according to one of claims 8, 11 to 13 characterised in that the deflection control (1) includes a fixedly settable beam path generator (1a, 1b).

## Revendications

1. Procédé pour la commande du taux d'évaporation qui est produit à l'aide d'au moins un rayon électronique (12) sur une surface d'évaporation (14) prédéfinie et dont la moyenne est calculée dans le temps, en vue d'une distribution de taux d'évaporation prédéfinie sur la surface (14), selon lequel on affecte à la surface (14) une grille de grandeurs de commande pour au moins un paramètre de fonctionnement du rayon électronique, et la surface (14) est soumise à un enlèvement de matière à l'aide du rayon électronique (12) commandé par les grandeurs de commande de la grille, caractérisé en ce que la grille de grandeurs de commande est définie par au moins une grille de grandeurs de correction (25) affectée à la surface (14) et divisée en champs (A, B, C...) qui sont affectés à des zones partielles de la surface et dans lesquels la grandeur de correction correspondante (K_{A}, K_{B}, K_{C}...) est constante, étant précisé que les zones partielles de la surface comprennent des zones partielles qui sont supérieures à celles qui pourraient être usinées par le rayon électronique maintenu stationnaire dans lesdites zones.

2. Procédé selon la revendication 1, caractérisé en ce qu'il est prévu plusieurs grilles de grandeurs de correction (74, 76) comportant chacune des divisions en champs (Aₐ, Bₐ, A_{b}, B_{b}), et la grille de grandeurs de commande (78, 84) est établie grâce à une combinaison de grandeurs de correction (K_{Aa}, K_{Ab}...) correspondant à des positions (x,y) identiques.

3. Procédé selon l'une des revendications 1 ou 2, caractérisé en ce que la grille de grandeurs de commande (78, 84) est établie à partir d'une ou plusieurs grilles de grandeurs de correction (74, 76), de préférence grâce au choix sélectif d'une combinaison d'une multiplicité de grilles de grandeurs de correction prévues.

4. Procédé selon l'une des revendications 1 à 3, caractérisé en ce que le rayon électronique (12) est guidé sur la surface de creuset (14) suivant le gradient (Δ) minimal des grandeurs de commande, éventuellement automatiquement.

5. Procédé selon l'une des revendications 1 à 4, caractérisé en ce que la division en champs (A, B...) de la ou des grilles de grandeurs de correction (74, 76) est prédéfinie et le réglage de grandeurs de correction (K) est réalisé individuellement à l'aide d'une unité de présélection (17), éventuellement suivant un réglage de base également prédéfini.

6. Procédé selon la revendication 4, caractérisé en ce que le rayon électronique (12) est guidé sur la surface (14) suivant les gradients de grandeurs de correction (Δ) minimaux de positions de rayon voisines.

7. Procédé selon l'une des revendications 1 à 6, caractérisé en ce que le rayon est guidé sur la surface de creuset (14) sur une trajectoire (B₁, B₂, B'₂) apte à être choisie.

8. Commande de rayon électronique pour une installation d'évaporation, comportant une commande de déviation (1) pour le rayon (12), qui commande la position de rayon (x, y) sur une surface d'évaporation (14) en vue de l'usinage de celle-ci, et une unité de commande (3b) pour la commande de paramètres de fonctionnement de rayon, caractérisée
- en ce que la commande de déviation (1) émet un signal d'identification de position (Nr) qui identifie une position de rayon (x, y) correspondant à une position sur la surface (14) qui est encore moins usinée que d'autres positions de la surface du creuset,
- en ce qu'il est prévu des moyens de mémorisation (7) pour la mise en mémoire de grandeurs de correction (K) pour des paramètres de fonctionnement de rayon,
- en ce qu'il est prévu des moyens d'affectation (5) qui affectent et sortent les emplacements de mémoire des moyens de mémorisation (7) avec la même grandeur de correction (K),
- en ce que les grandeurs de correction (K) sorties sont transmises sous la forme d'une grandeur de commande (S₁₃) à au moins une entrée de commande de l'unité de commande (3b),
- en ce que la commande de déviation (1) commande le rayon (12) dans une position suivante.

9. Commande selon la revendication 8, caractérisée en ce qu'il est prévu une unité de sélection (52, 54) qui cherche pour le rayon (12), à partir d'une position réelle du rayon (12) définie par un signal d'identification (Nr), de l'emplacement de la mémoire de grandeurs de correction (7) affecté à cette position et de la grandeur de commande momentanée, une position dont la grandeur de commande affectée dépendante de la grandeur de correction dans la mémoire de grandeurs de correction (7) s'écarte de façon minimale de la grandeur de commande dépendante de la grandeur de correction suivant la position momentanée, et en ce que l'unité de sélection (54) émet un signal de commande de position (mₘᵢₙ) pour le rayon (12) afin de guider celui-ci dans la position trouvée comme position suivante.

10. Commande selon l'une des revendications 8 ou 9, caractérisée en ce que la commande de déviation (1) guide le rayon (12) sur la surface (14) suivant une grille de positions prédéfinie, et l'unité de sélection (52, 54) sélectionne comme position suivante une position qui est voisine de la position momentanée sur cette grille.

11. Commande selon l'une des revendications 8 à 10, caractérisée en ce qu'il est prévu plusieurs moyens de mémorisation (7ₐ, 7_{b}...) pour des grandeurs de correction respectives (K_{Xa}, K_{Xb}...), en ce que les moyens d'affectation (5a, 5b...) affectent à plusieurs positions de rayon des emplacements de mémoire ayant les mêmes contenus (K), dans chaque moyen de mémorisation (7ₐ, 7_{b}...), et en ce que les sorties des moyens de mémorisation (7ₐ, 7_{b}...) agissent sur une unité logique (72) dont la sortie (S₁₃) agit elle-même sur l'unité de commande (3b) avec au moins une grandeur de commande.

12. Commande selon la revendication 11, caractérisée en ce que l'un au moins des moyens de mémorisation (7ₐ, 7_{b}...) est apte à être mis en oeuvre à l'aide d'un dispositif additionnel (70).

13. Commande selon l'une des revendications 8 à 12, caractérisée en ce que les grandeurs de correction (K) prévues au niveau des moyens de mémorisation (7) sont aptes à être ajustées extérieurement, au niveau d'une unité de présélection (17).

14. Commande selon l'une des revendications 8, 11 à 13, caractérisée en ce que la commande de déviation (1) comprend un générateur de trajectoire de rayon (1a, 1b) apte à être réglé de façon fixe.
